# EUROPEAN PATENT SPECIFICATION

(11) **EP 0 839 440 B1**
(45) Date of publication and mention of the grant of the patent: **03.11.1999**
(21) Application number: 95924475.7
(22) Date of filing: 20.07.1995
(51) Int. Cl.: H05K 3/38

(54) **COPPER FOIL FOR THE MANUFACTURE OF PRINTED CIRCUITS AND METHOD OF PRODUCING SAME**
KUPFERFOLIE FÜR GEDRUCKTE SCHALTUNGEN UND VERFAHREN ZU IHRER HERSTELLUNG
FEUILLE DE CUIVRE POUR LA FABRICATION DE CIRCUITS IMPRIMES ET SONPROCEDE DE PRODUCTION

(43) Date of publication of application: 06.05.1998
(73) Proprietor: Circuit Foil Luxembourg Trading S.a.r.l., Luxembourg (LU)
(72) Inventor: ACX, Kurt, L-9576 Weidingen (LU); DUFRESNE, Paul, Langhorne, PA 19047 (US); MATHIEU, Michel, B-6600 Bastogne (BE); STREEL, Michel, B-6662 Houffalize (BE); WOLSKI, Adam, M., Edgewater Park, NJ 08010 (US)
(74) Representative: Weyland, J.J. Pierre
(86) International application number: IB9500571
(87) International publication number: WO9704627

(56) References cited:
- US-A- 4 387 006
- US-A- 5 071 520
- M. HUSCHKA: "Einführung in die Multilayer-Pre$technik" , , EUGEN G. LEUZE VERLAG, SAULGAU, DE (1988),P.27-29
- A.J.KINLOCH: "Adhesion and Adhesives" , , CHAPMAN AND HALL,, LONDON NEW YORK (1987),P.61-66

## Description

### FIELD OF THE INVENTION

This invention relates to a method of protecting the surface of copper foil against tarnishing and oxidation, and to electrodeposited copper foil suitable for use in the manufacture of printed circuit boards, especially multilayer printed circuit boards.

### BACKGROUND OF THE INVENTION

The production of copper foil for electronic applications, e.g., copper-clad laminate for printed circuit boards, involves the use of a well-known electrodeposition process. This process utilizes a large cylindrical drum cathode which rotates, partially immersed in a copper sulfate-sulfuric acid electrolyte. The drum cathode is adjacent to and facing toward a pair of curved anodes, which may be formed of lead, lead-antimony, platinized titanium, iridium or ruthenium oxides. Both the drum and the anodes are connected electrically by heavy buss-bars to a D.C. power source and currents of up to 50.000 A or more are commonly used. As the drum rotates in the electrolyte, an electrodeposit of copper forms on the drum surface, and as the latter leaves the electrolyte, the electrodeposited copper is continuously stripped from the rotating drum in the form of thin foil, which is slit to size and wrapped around a take-up roll. The top surface of the drum is usually formed of stainless steel, titanium or chromium.

Foil produced in such a process, prior to being treated, is usually referred to as raw foil. The raw foil is pale pink in color and has two distinctly different looking sides - a "shiny side", the side which was plated onto the drum surface and then stripped is quite smooth while the other side, the side which was facing toward the electrolyte and the anodes, is referred to as the "matte" side since it has a velvety finish. The matte side can be imagined as a set of closely packed cones having heights from three to ten microns, the cone heights depending upon the independent variables of foil thickness, current density, solution composition, and the like. This provides the basic shape of the foil surface for embedding in the resin of a substrate to promote adhesion in the copper-clad laminates used in the manufacture of printed circuit boards (PCBs).

While the matte side of the foil has a certain micro-roughness, a surface bonding treatment is typically applied to the matte side of the raw foil to ensure adequate bonding strength after the copper-clad laminate is formed. The term "bonding treatment" is universally used to refer to changing one or both surfaces of the electroformed foil to make it suitable for bonding to laminate resins.

The bonding treatment operation is conducted in machines called "treaters" wherein rolls of raw foil are unrolled in a continuous manner and fed into the treater by means of driven rollers (similar to the way in which a web of paper is handled in a printing machine), rendered cathodic by means of contact rollers and passed in a serpentine fashion through one or more plating banks. facing, in each tank, a rectangular anode. Each tank has its own supply of appropriate electrolyte and its D.C. power source. Between the tanks, the foil is thoroughly rinsed on both sides. The purpose of this operation is to electrodeposit on at least one side of the foil, usually the matte side. micro-projections of complex shape which ensure that the foil will be firmly anchored to the base polymeric materials used in fabricating the copper-clad laminates.

Peel strength (the force necessary to pull apart the copper foil and the supporting insulating substrate material) is a characteristic of the highest importance, since the mechanical support of the circuit elements as well as the current carrying capability of PCBs is provided by the copper foil-polymer joint. It is essential that the foil is bonded very tightly and securely to the substrate and also that such an adhesive joint can withstand all the manufacturing steps in the fabrication of PCBs without the decrease of the initial adhesion, which, moreover, should remain constant throughout the service life of the PCB.

This bonding operation is carried out in laminating plants and involves heating and cooling cycles. Sheets of copper foil are laid upon sheets of "prepreg" (e.g., glass fabric impregnated with epoxy resin). Both materials are placed in a hydraulic press having heated pressing plates, and the two materials are pressed together under high pressure. At elevated temperatures the resin liquefies and is forced, by the pressure, to flow into the micro-irregularities of the foil surface. This is followed by a second cycle, when both materials are cooled, while the pressure is being maintained. the resin solidifies in the irregularities of the foil surface and both materials are firmly bonded together with the result that it becomes very difficult to pull them apart. It is the responsibility of the matte side of the foil to ensure high peel strength.

The matte side of the finished foil, i.e., the base foil plus treatment, refers to the combined effect of the micro-topography of the matte surface of the base foil (electrodeposited at the drum machine) and the bonding treatment plated upon that surface at the treater machine. Both are equally important.

Until only a few years ago the main segment of the total output of PCBs was represented by single-sided and particularly double-sided boards. Classical copper foil is an ideal material for the manufacture of such boards.

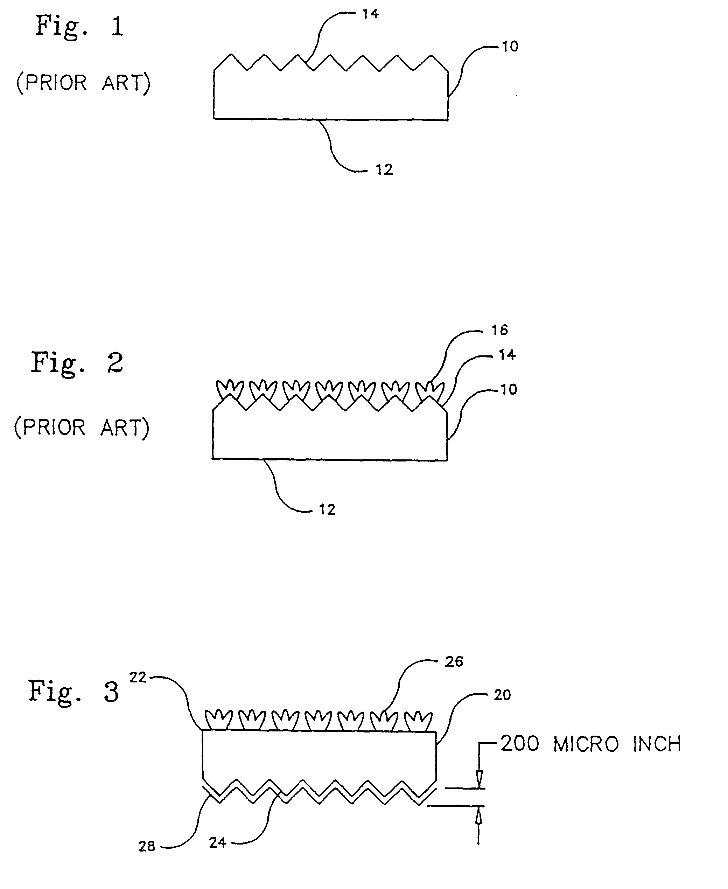

As shown in Fig. 1, metallographic cross-sectioning of copper base foil 10 reveals that the foil's two opposing surfaces are not the same. While the surface formed next to the drum 12. the shiny side of the foil is relatively flat and smooth, even when viewed under great magnification, the surface formed next to the electrolyte 14, the matte side of the foil, has micro-peaks and valleys. As shown in Fig. 2, the matte side, after application of the bonding treatment, comprises an extremely dense and uniform coating of spherical micro-projections 16 which greatly enhance the surface area available for bonding to the polymeric substrates.

The shiny side of the foil, after the lamination, represents the processing side of the copper-clad laminate. As such, it serves as a substrate for image patterning and soldering to ensure the necessary electrical connections between components. In the fabrication of multilayer PCBs (MLBs). the shiny side of the foil also serves as a surface to be treated by chemical means (brown oxide or black oxide treatment) for bonding purposes.

Although many properties of the copper foil are important in the fabrication of rigid single or double-sided PCBs, the peel strength is one of the most important. It has to be remembered that copper cladding constitutes the external surface of the laminate, and that thin copper foil lines can be relatively easily lifted off the surface of the insulating base material if the peel strength is not excellent.

This is why copper foil manufacturers take advantage of the "natural" micro-roughness of the matte surface of the base foil, which at that stage already has a potential "bondability" to polymers, and further enhance it with bonding treatment to achieve the highest possible final peel strength. This is not necessary, or indeed a desirable characteristic of copper foil if it is destined for the manufacture of multilayer boards, which now dominate the PCB market. In the case of the inner layers of MLBs, copper foil is encapsulated or "sandwiched" between the layers of prepreg, and moreover, the double-sided laminates for inner layers are quite thin. That raises the need for "low-profile". "not-too-high peel strength" copper foil so that the laminate's dielectric properties are not adversely affected, which frequently is a result of excessive bonding treatment.

On the other hand, the fact that the top side (shiny side of the foil) is laminated against a prepreg that separates it from the next inner layer raises the question of reliability of such an adhesive joint. The shiny side of the foil is quite smooth and offers little "bondability." This is why manufacturers of MLBs apply a so-called oxide treatment to the top side of copper tracks, to enhance their bondability.

It is widely accepted practice in the manufacturing of MLBs to use oxidation techniques to promote the adhesion between the copper surface of the inner layers and the prepreg. Without oxide treatment, the bond between copper and the prepreg layer is insufficient to withstand the thermal shock of reflow soldering.

During the formative years of the multilayer board industry, with relatively less dense patterns of the inner layer circuitry, the bond between the prepreg and the base laminate of the inner layers was not considered important. It was believed that copper tracks could be encapsulated in the cured prepreg. On the other hand, today's internal circuitry is very dense and most of the bonding is to copper rather than to base laminate. Today, the surfaces of copper tracks have to be "adhesion-prone".

The oxide treatment techniques used in the fabrication of MLBs are troublesome. expensive and create their own technical problems. One is the so-called "pink ring" which results from the chemical attack on copper oxide layers by the chemicals used in through-hole plating. It is customary now to use additional steps of brown oxide treatment, which involves the reduction of cupric oxide to metallic copper, since the bonding treatment with copper is immune to pink ring, as opposed to CuO which is easily dissolved in mineral acids. This reduction step further complicates brown oxide processes and renders them even more expensive.

It has been proposed that a special copper foil provided with the bonding treatment on the shiny side of the foil is better suited to the fabrication of MLBs. If the bonding treatment is plated onto the drum side of the foil this results in a lower peel strength (e.g. about 1.4N/mm (8 lbs./inch)) than when the same treatment is plated onto the matte side of the foil (e.g. about 2.1 N/mm (12 lbs./ inch)). Nevertheless, such peel strength is more than adequate in MLBs.

With respect to copper foil destined for use in producing MLBs, we have found that the brown oxide treatment which is presently applied to the shiny side of the foil and provides a quite low peel strength can advantageously be applied to the matte side of base foil, which by itself, due to its peak and valley topography and the resulting micro-roughness, has a considerable peel strength of about 0.7 N/mm (4 lbs/inch), as opposed to the shiny side of the foil, which has substantially no peel strength at all. When this is done, very little brown oxide has to be applied to the matte side of the foil to bring the peel strength to the desired level of, for example, 1.23 N/mm (7 lbs/inch) or so. This reduced amount of brown oxide is much less fragile in terms of structure, than the greater amount of brown oxide that has to be applied to the shiny side of the foil to achieve the same peel strength. The need for reduction of cupric oxide to metallic copper can thus be eliminated, and the entire process becomes simpler and less expensive, while the quality of MLBs (particularly the dielectric properties and the resistance to delamination due to solder shock) are improved.

However, the change in the process of manufacturing this special copper foil, when compared to the classical process, requires more than the mere application of bonding treatment to the shiny side, rather than to the matte side, of the base foil.

Since the matte side of this special foil will first be subjected to "imaging" when a circuitry pattern is transferred to a panel, and then to brown oxide treatment, the usual method of "stainproofing" the matte side to protect it from tarnishing and oxidation should be reformulated to render it more suitable for use in commercial operations.

Brown oxide treatment for MLBs and micro-etching techniques have in common the property that either a sodium chlorite or a sulfuric acid peroxide micro-etching solution must reach the surface of the copper to produce uniformly the desired reaction or effect. Stainproof layers, therefore, have to be either easily removed by precleaning solutions or be easily penetrable by brown oxide or micro-etch liquids. Excessively tenacious stainproof layers can form an impenetrable shield between the surface of copper and the processing chemicals, delaying the desired reactions or producing obvious non-uniformity.

With the advent of miniaturized electronics, very densely packed printed circuit boards are needed. Miniaturization often requires that the copper foil conductor, or track lines, of today's printed circuit board be as narrow as 127 microns (5 mils) or less. The degree of high definition of fine-line circuitry depends on the quality of copper foil manufactured for the electronic industry, particularly on the surface quality of poth sides of the foil.

It is the practice in the manufacture of printed circuit boards from copper-clad laminate to form the image of the desired printed circuit pattern on the copper surface of the laminate by a photographic technique which leaves the desired pattern formed of a photoresist material on the surface of the copper. For the photographic imaging to be sharp and precise, photoresist has to spread well on the foil's surface and adhere well to it.

it is a practice in the manufacture of printed circuit boards to roughen the surface of the shiny side of the copper foil to achieve good resist adhesion. This roughening also removes tenacious stainproof films which foil manufacturers apply to the foil to protect it from oxidation and staining before it reaches the user. Photoresist does not adhere to the stainproof films, which therefore have to be removed. Thus, roughening of the foil surface serves the purpose of removal of stainproof film as well as changing the copper surface topography from smooth to micro-rough, to facilitate photoresist adhesion, which is a condition of good definition of track lines.

This roughening is performed either by mechanical means (e.g. abrasion by brushes. scrubbing with pumice) or chemical means (so-called micro-etching), which is accomplished by subjecting the copper surface of copper-clad laminates to the etching action of oxidizing mineral acids. Such acids attack the smooth surface of the foil along the copper grain boundaries, thus creating pits and pores and change the copper surface from smooth to micro-rough.

In the fabrication of MLBs. copper foil is laminated (bonded to polymeric substrates twice). First, thin, double-sided copper-clad laminates are produced. These laminates are then subjected to image patterning and etching away of unwanted copper to produce the desired patterns of circuitry. Several layers of double-sided boards prepared in such a manner are stacked together, with sheets of prepreg inserted in between to separate dielectrically each inner board from the other. Such a stack of circuit boards and prepreg is then laminated together to form a monolithic multilayer board. Later, holes are punched or drilled through the board in prearranged places and so-called through-hole plating of copper is used to ensure the electrical interconnection between all layers of copper-track conductor lines.

Good bonding is required between the top surfaces of track lines (the surface which was used for image patterning) and the sheets of prepreg, in the course of second (so-called B-stage) lamination.

It is a practice in the fabrication of MLBs to subject the inner layer boards, with their patterns of circuitry, to the so-called brown oxide treatment, which changes the micro-topography of the top surfaces of the track lines to improve their bondability to the polymeric prepreg. This brown oxide treatment is produced by immersing the boards in an alkaline solution of sodium chlorite which, by its oxidizing action, causes the conversion of metallic copper on the top surfaces of exposed copper tracks into cupric oxide (CuO), possibly in an admixture of cuprous oxide (Cu₂O), depending on the type of the bath and operating conditions. This oxide coating grows in the form of dendritic crystals, perpendicular to the surface of the copper tracks. Thus, the surface area available for bonding to polymeric substrates is increased and improved bondability is achieved.

Various patents directed to bonding treatments for copper foil disclose that one or both sides of the foil which is to be bonded to the substrate is subjected to bonding treatment (U.S. Patent 5.207.889), or that treatment for copper foil that is to be used for lamination to a board comprises electrodepositing a dendritic layer of copper followed by a gilding layer of copper on the side of the foil that is to be laminated to the board (U.S. Patent 4.572.768). Also, the use of either the shiny or matte side of the foil to achieve flexibility in terms of surface characteristics of the resulting copper-clad laminates, which have either a mirror-like shiny side or "copper-clad laminate having a satin finish" (matte side) is disclosed in U.S. Patent No. 3.998.601. U.S. Patent No. 3.857.681 discloses the application of copper dendritic and gilding layers to at least one of the surfaces of copper foil to improve the bond strength when laminated to a polymeric substrate, followed by the application of a zinc coating to prevent laminate staining or discoloration.

US patent 5.071.520. which forms the basis for the preamble of appended claim 1, discloses a method of treating metal foil to improve pell strength and discloses a copper foil suitable for use in the manufacture of printed circuit boards. The foil comprises an electrodeposited copper base foil having a matte surface and an opposing shiny surface and discloses the use of an oxidation-and-tarnish-resistant protective layer provided on one surface and the use of an electrodeposited bonding treatment provided on the opposing surface.

The application of a stainproofing chromate layer on the surface of copper foil to protect against tarnish and oxidation, as disclosed in U.S. Patent Nos. 3.625.844 and 3.853.716, is also known.

The matte side of the foil, with its own micro-roughness and the resulting bondability, is a better surface upon which to grow the layer of brown oxide, than the traditionally used shiny side of the foil, even if it is roughened by either micro-etching or mechanical abrasion

### SUMMARY OF THE INVENTION

It is the general object of the present invention to provide a method of controlling the surface characteristics of the matte surface of copper foil to make it particularly suitable for high-resolution image patterning and also a method of providing the matte surface with a stainproofing layer which in the course of fabrication of printed circuit boards can be easily removed by dissolution in aqueous solutions of alkalis. Other objects and advantages of the present invention will become apparent from the following description thereof and from the practice of the invention.

To achieve the objects of the present invention there is provided a method for protecting the surface of copper foil against tarnishing and oxidation as described in the appended claims.

In accordance with the present invention, the matte side of the foil is provided with a stainproofing layer (derived from the stainproofing electrolyte and applied electrolytically to the foil's surface) which, while protecting the foil from oxidation prior to the foil's use, can be easily removed from the surface of copper-clad laminate by simple immersion in a dilute alkaline solution such as aqueous sodium or potassium hydroxide as a low temperature (e.g. about 8 lbs./inch and approximately ambient), without the need for brushing, scrubbing or micro-etching.

The purpose of the stainproofing process in the manufacture of copper foil is to form on the surface of the foil a protective coating which extends the shelf-life of the foil by protecting it against atmospheric oxidation as well as from oxidation at elevated temperatures used during the laminating processes by which copper-clad laminates are fabricated.

The stainproofing layer which protects the copper foil against oxidation has functions other than just extending the shelf-life of the foil. Once the copper-clad laminates are ready for further processing, the protective layer has to be easily removed from the image patterning side of the foil by quick and complete dissolution in alkalis, since the complete removal of stainproofing compounds is required to assure good adhesion of photoresists, unhindered response to the etchants and good acceptability of brown oxide treatment. Thus, the type, structure, chemical composition and the thickness of the stainproofing layer that protects the "processing" side (the side subjected to imaging) of the foil is extremely important.

The present invention takes advantage of the fact that copper foil produced by means of electrodeposition on a rotating drum cathode possesses two top surfaces which are not the same. While the surface next to the drum, the shiny side of the foil, even when viewed under great magnification, is relatively flat and smooth, the surface next to the electrolyte, the matte side of the foil, is already micro-rough (viewed under a high-resolution electron microscope, the surface is seen to be composed of micro-peaks and micro-valleys). Moreover, the degree of micro-roughness can be controlled in this case by the manufacturer of copper foil much better than when mechanical or chemical roughening is carried out by the manufacturer of printed circuit boards.

Thus, a laminate produced by bonding foil matte-side-up to the polymeric material assures excellent photoresist adhesion and thus a high degree of fine-line precision of definition. The bonding treatment applied to the shiny side (or drum side) of the foil assures good anchoring of track lines to the polymeric substrates.

There is a further advantage of the present invention that results from fabrication of the copper foil with the bonding treatment applied to the shiny side of the foil and using the matte side for the image patterning. This advantage lies in the fact that such foil is particularly well adapted for use in the manufacture of MLBs which now dominate the printed circuit board market, because they can achieve the highest functional density of circuitry in electronic packaging.

### BRIEF DESCRIPTION OF THE DRAWINGS

The following description of the present invention will be better understood by reference to the accompanying drawings, which form a part hereof. In the drawings:
Fig. 1 illustrates conventional copper base foil;
Fig. 2 illustrates conventional finished copper foil having a bonding treatment applied to the matte side thereof; and
Fig. 3 illustrates copper foil in accordance with the present invention.

### DESCRIPTION OF THE INVENTION AND A PREFERRED EMBODIMENT THEREOF

Referring to Fig. 3, finished copper foil in accordance with the present invention comprises an electrodeposited copper base foil 20 having a matte surface 24 on which there is electrodeposited a protective layer 28 containing zinc and one or more compounds of trivalent chromium, referred to hereinafter as a chromate or chromates. The foil 20 has a smooth or shiny side 22 on which there is an electrodeposited bonding treatment 26. The matte surface of the raw foil preferably has a surface roughness, or R_{Z} (as hereinafter defined) of from about 3 to about 10. most preferably about 5 microns.

The base foil may be formed by any of the well-known techniques for producing copper foil, such as the one wherein a thin foil is electrodeposited from a copper ion-containing electrolyte onto the smooth surface of a rotating drum cathode partially immersed in the electrolyte and then stripped from the surface of the drum, slit and rolled. The copper foil so produced has one surface, on the drum side, which is smooth or shiny and another surface, on the opposing electrolyte side, which is matte.

In the fabrication of copper-clad laminates for printed circuits, copper foil is bonded to a polymeric substrate (a composite material such as epoxy, polyimide or a like resin reinforced with glass fiber fabrics) by means of mechanical interlocking at the interface between the two materials.

To achieve a high degree of interlocking, the bonding side of the foil is provided with a bonding treatment. Such treatment consists of an extremely dense coating of copper spherical micro-projections, which is electrodeposited to the shiny or smooth (drum) side of the base copper foil.

The peel strength of copper foil (the force necessary to separate, or pull away the foil from the polymer substrate) will depend on the shape of the individual micro-projections, their mechanical strength and hardness, density per surface area and their distribution over the smooth surface of the drum side of the base foil. In turn, all the factors listed above will depend on the conditions under which the bonding treatment is electrodeposited.

The preferred bonding treatment is effected by subjecting the shiny side of the base or "raw" foil to four consecutive electrodeposition steps. The first consists of the deposition of a micro-dendritic copper layer which enhances, to a very large degree, the real surface area of the matte side, and thus enhances the foil's bonding ability. It is followed by electrodeposition of an encapsulating, or gilding layer, the function of which is to mechanically reinforce the dendritic layer, and thus render it immune to the lateral shear forces of liquid resins in the laminating stage of PCB fabrication. Then, a so-called barrier layer is deposited on the dual-layer copper treatment, after which a stainproofing layer is applied.

The purpose of the dendritic deposit is to increase the "true" surface area of the shiny side, since that property is ultimately responsible for the bonding characteristics of the foil. The shape, height, mechanical strength and the number of dendritic micro-projections per surface area which constitute the dendritic deposit are the factors instrumental in achieving adequate bond strength of the foil, after all stages of the treatment are completed. The dendritic deposit, the first stage of the treatment, is relatively weak mechanically and given to unacceptable treatment transfer characteristics.

The encapsulating step of the treatment is very important, since it eliminates the foil's tendency to "treatment transfer" and the resulting "laminate staining" which can cause the decrease of the laminate's dielectric properties. The role of this second treatment stage is to mechanically reinforce the fragile dendritic layer, by overplating it with a thin layer of sound and strong metallic copper, which locks the dendrites to the base foil. Such a dendrite-encapsulation composite structure is characterized by high bond strength and the absence of treatment transfer. The treating parameters which assure this are relatively narrow. If the amount of the gilding deposit is too low, the foil will be given to treatment transfer. If, on the other hand, the gilding layer is too thick, a partial loss of peel strength may be expected. These first two layers of the treatment are composed of pure copper, in the form of microscopic, spherical micro-projections.

The dual-layer copper bonding treatment may have electrodeposited thereon a very thin layer of zinc or zinc alloy, a so-called barrier layer. During the fabrication of copper-clad laminates destined for PCBs, the zinc-containing layer alloys with the underlying all-copper bonding treatment by the process of heat-accelerated diffusion of metals in the solid state. As a result, a layer of chemically stable alpha brass is formed over the surface of the all-copper treatment. Its purpose is to prevent direct copper-epoxy resin contact, and this is why the zinc-containing layer (which during lamination is converted to alpha brass) is referred to as a barrier layer. If the bonding treatment, composed of copper only, is subjected to lamination with epoxy resin systems, it tends to react with amino groups of the resin, at the high laminating temperatures. This, in turn, may create moisture at the foil-resin interface, causing the harmful effect of "measling", and possibly delamination. The barrier layer plated over the all-copper bonding treatment prevents these harmful effects.

All three stages of the treatment mentioned above, as is well known in the art, are effected by means of electrodeposition, which changes the geometry and morphology of the smooth side of the foil and assures the mechanical strength of the surface region.

The foil treated as described above may then be subjected to an electrochemical stainproofing which changes the surface chemistry. As a result of this step, the bonding surface is rendered chemically stable. This stainproofing operation removes weak surface films, which can greatly decrease the adhesion of the foil to the substrate, and provides a stable film of controlled thickness, responsible for imparting to the treated surface the "durability" of its properties.

The above bonding treatment, barrier layer and stainproofing may be applied to the shiny surface of the base foil by the methods disclosed in U.S. Patent No. 4.572.768 (Wolski et al.), U.S. Patent No. 5.207.889 (Wolski et al.), U.S. Patent Re 30.180 and/or U.S. Patent No. 3.857.681 (Yates et al.).

The proper chemical composition and the thickness of the stainproof layer are very important in achieving a good, easily removable stainproof layer. while not diminishing its protective ability.

Providing the matte side of the foil with the layer of stainproofing in accordance with the present invention involves the simultaneous deposition of chromate ions and metallic zinc, and this is a very unusual case of alloy plating, since one constituent of the electrolyte, chromic acid, is reduced at the foil surface (cathode), not to a metallic state, but to a trivalent state, which in turn enables the formation of a chromate stainproofing layer on the matte surface 24.

The stainproofing electrolyte used in the present invention has the dual function of chromating and zincating, and thus forms the protective layer of the stainproofing of the present invention, which is also dual in its protective role, offering both mechanical protection, typical of conversion coatings, as well as electrochemical (sacrificial) protection, typical of zinc coatings.

The factor which enables the co-deposition of chromates and metallic zinc is the pH of the electrolyte. At very low pH values, e.g. a pH of 2 (which is the value for 3 g/l CrO₃). hexavalent chromium compounds are very strong oxidants. thus counteracting the cathodic reduction of zinc. At such a pH, the standard electrode potential E₀ has a value of +1.33 V for the following reaction:

Cr₂O₇²⁻ + 14H⁺ + 6e = 2Cr³⁺ + 7H₂O

and under such conditions co-deposition of zinc is impossible. In basic solutions, chromates rather than dichromates are the prevailing species, and are by and large much less oxidizing.

The reaction:

CrO₄²⁻ + 4H₂O + 3e = Cr(OH)₃ + 50 H⁻ E₀ = 0.13 V

is much closer to the standard electrode potential of zinc E₀ -0.76 and enables the deposition of the chromates and metallic zinc.

In accordance with the present invention, the bulk of the electrolyte is moderately acidic, and preferably has a pH value of from about 3 to about 4.5, most preferably from about 3.5 to about 4, and typically the electrolyte has a pH of about 4 which is, of course, far from basic, but it refers to the bulk of the electrolyte. The pH at the foil-solution interface, however, exceeds 7. Whenever there is a flow of current, there is necessarily a reduction of some chemical species at the cathode (foil). In the present process cathodic reactions are:
Reduction of Cr⁶⁺ (see above)
Reduction of zinc Zn²⁺ - 2e = Zn
Reduction of water 2H₂O + 2e = 20H⁻ + H₂

It is the last reaction, i.e., evolution of hydrogen at the foil surface, which is responsible for the above-mentioned local increase of pH, thus allowing for simultaneous precipitation of a chromate layer and the deposition of zinc.

It has been found, by studying the chemical composition of experimental stainproof layers, using instrumental methods of surface analysis (scanning auger microprobe, and ESCA (electron spectroscopy for chemical analysis)), that stainproofing layers capable of good protective action while also being easily removable by immersion in alkalis, typically contain about 10-20% of chromium (calculated as metallic chromium) and 20-40% of zinc (calculated as metallic zinc), the balance being water, and are less than 10 nm (100 Å) thick. The ratio of chromium to zinc is very inportant. The relatively high zinc content in the layer assures that the layer is easily dissolved by alkalis; due to the amphoteric character of this metal it dissolves in sodium hydroxide forming sodium zincate with copious evolution of hydrogen. Therefore, the stainproofing layer should have a zinc to chromium ratio (both calculated as the metal) of at least 1:1, and preferably about 2:1, by weight.

Since the atoms of zinc are uniformly dispersed within the lattice of the chromates, such as the chromium hydroxide component of the protective layer, alkaline cleaners attack and dissolve atoms of zinc, hydrogen is formed, and this combined effect of alkaline attack and "fizzing" lifts chromium compounds off the surface of the foil, leaving it, after the rinse, pure and clean, and ready for further PCB processing.

The following electrolyte and electroplating conditions may be used to form the stainproofing layers described above:

### ELECTROLYTE

CrO₃ - 0.75 grams/liter (g/l) - 2 g/l; preferably 1.25 g/l
Zn (calculated as Zn) - 0.3 g/l- 1.0 g/l; preferably 0.5 g/l
H₃PO₄ - 0 g/l - 2 g/l; preferably 0.5 g/l
H₂O - balance

### ELECTROPLATING CONDITIONS

pH 3,5 - 4.0
T - 32°C (90°F)
Current density - 46 A/m² (0.5 A/ft²)- 185 A/m² (20 A/ft²);
preferred 93 A/m² (10 A/ft²)

Plating time - 1 second to 5 seconds; preferred 3 seconds. The copper foil is rendered cathodic with respect to the anode, immersed in the bath, and facing the foil, and thus electrodeposition of the stainproofing layer is accomplished. The present stainproofing method is an improvement in the prior stainproofing methods disclosed in U.S. Patent No. 3.625.844 (McKean) and U.S. Patent No. 3.853.716 (Yates et al.).

It has been found that the ability of the stainproof layer to protect the "processing" side of the copper foil or the copper-clad laminate from various forms of oxidation, while maintaining the layer behind easily removable by chemical means, can be further enhanced by plating on the matte side of the foil an extremely thin layer of zinc prior to the deposition of the stainproof layer to the same side of the foil.

The explanation of this improvement is as follows: of the two components of the stainproof layers, zinc assures the resistance of the copper surface it protects to direct oxidation, due to the heat of the laminating process and the post-bake. In addition, due to its amphoteric nature, zinc is easily soluble in both mineral acids and alkalis, and thus contributes toward easy removal of the protective layer by chemical means.

The trivalent chromium component of the layer is responsible for protecting the copper surface against atmospheric or "wet" corrosion and thus provides the copper foil with a good shelf-life. Chromium compounds, however, bound chemically to the copper surface, are much less soluble than zinc in the acids and alkalis, and are therefore much more difficult to remove by chemical means than the zinc component of the protective layer.

Eventually, the compromise between protective action and cleanability is reached by the careful choice of the proportion of zinc and chrome compounds in the stainproof layer and also of the thickness of the protective film.

The nature of the process ensures that the distribution of both elements and their ratio throughout the thickness of the layer is uniform.

Obviously, the best way of resolving the conflicting requirements of protection and removability aspects of the stainproof layer would be if the depth profile of this layer favored zinc right next to the surface of the metallic copper, for the first 2 nm (20 Å) or so of the total 10 nm (100 Å) thickness of the stainproof layer. The remaining 8 nm (80 Å) of the layer, toward its outer perimeter, should consist of the zinc composite and the compounds of trivalent chromium in the proportions described previously.

If the thin coating of the metallic zinc, without chromium compounds, is immediately adjacent to the surface of the metallic copper, the ability of zinc to sacrificially protect copper against direct oxidation is even better than the protective ability of the stainproof film alone.

Similarly, the presence of a pure zinc coating next to the copper surface further facilitates the easy and complete removal of the protective film by chemical cleaners.

The deposition of the very thin coating of metallic zinc prior to the deposition of the stainproof layer is effected in a separate plating tank of the treater machine by a cathodic process. The foil is rendered cathodic in the said tank. An anode faces the processing side of the foil. The electric circuit is thus completed and, by controlling the amount of flowing current, the desired thickness of zinc coating can be deposited onto the copper surface. This coating is then followed by the deposition of a stainproof layer in the next plating tank of the treater machine.

if desired, the same stainproofing may also be applied to the shiny side of the foil having the above-described bonding treatment.

The bonding treatment plated onto the drum or shiny side of the foil results in lower peel strength than the same bonding treatment plated onto the matte side of the foil (about 1.4 N/mm (8 lbs/inch) rather than 2.1 N/mm (12 lbs/inch)). Nevertheless, such lower peel strength is mcre than adequate in MLBs. On the other hand, when the brown oxide treatment, presently applied to the shiny side of the foil and supplying quite low peel strength, is applied to the matte side of the base foil (which by itself, due to its peak and valley topography and the resulting micro-roughness has a considerable peel strength of about 0.7 N/mm (4 lbs/inch), as opposed to the untreated shiny surface of the foil, which has substantially no peel strength at all), relatively little brown oxide has to be applied to the matte surface of the foil to bring the peel strength to the desired level of about 1.05 N/mm (6 lbs/inch). This reduced amount of brown oxide is much less fragile in terms of structure, than the greater amount of brown oxide that is presently applied to the shiny surface of the foil to achieve the same peel strength. When the matte surface of the foil is subjected to the brown oxide treatment, the need for reduction of cupric oxide to metallic copper is eliminated, and the entire process becomes simpler and less expensive, while the quality of the MLBs (particularly the dielectric properties and the resistance to delamination due to solder shock) are improved.

When the shiny surface of the copper foil is used as the processing side of the foil, cleaning and roughening of the surface prior to resist (both etch resist and plating resist) application is critical. Since there is less surface are for the resist to cling to, that surface must be at an optimum state in order for the resist to adhere and provide a successful etch. An area where the resist lifts at the edge of a circuit trace or where there is a deep gouge that the resist does not fully cover could mean an etched-through trace which may require expensive repair or even the scrapping of the board altogether. Such cleaning and roughening of the process side of the copper foil is accomplished by the use of the well-known mechanical scrubbing and micro-etching techniques, the need for which is obviated by copper foil in accordance with the present invention.

The following example describes a preferred embodiment of the present invention and demonstrates certain advantages thereof.

### EXAMPLE

A web of base (or raw) foil, 35 microns thick (so-called one-ounce foil in terms of weight per surface area), was produced by means of electrodeposition of copper on a rotating drum cathode, using the electrolyte, grain-refining agents and plating parameters described in column 17 of U.S. Patent No. 5.215.646 (Wolski. et al.), except that only primary anodes, and not the secondary anode, were used.

This base foil had one top surface which was smooth or shiny, and another opposite top surface which was matte because of its complex micro-topography. The second surface was composed of micro-peaks and micro-valleys, which together formed the matte side's micro-roughness. The matte side of the foil was examined for micro-roughness (by a stylus-type instrument) and was found to be 5,3 microns (210 micro-inches).

The base foil described above was, in turn. passed through a treater machine in order to provide the shiny side of the foil with a multilayer (copper dendritic layer, copper gilding layer and a barrier layer) bonding treatment, and to provide the matte side of the foil with an easily removable stainproofing layer.

This multilayer bonding treatment applied to the shiny side of the foil employed the techniques. plating parameters and the electrolytes described in U.S. Patent No. 4.572.768 (Wolski et al.), to produce a treated side.

The matte side of the foil was provided with an easily removable (by means of dissolution in 5% solution of sodium or potassium hydroxide stainproofing film. The technique of electrolytic copper stainproofing process used was based on U.S. Patent No. 3.853.716 (Yates et al.), using an electrolyte comprising:
CrO₃ - 1.0 g/l
Zn (added as ZnSO₄) - 0.4 g/l
H₃PO₄ - 0.5 g/l
H₂O - balance
pH - 3.9
T - 32°C (90°F)

The stainproofing layer was deposited electrolytically on the matte side of the foil (which was used as a cathode), employing a current density of 18.5 A/m² (2A/ft²) and a plating time of 1.5 seconds. The resulting stainproofing layer was examined and found to comprise metallic zinc and chromates and to have a zinc to chromium ratio of 1.85:1.0.

The copper foil produced in the manner described above was then subjected to the following tests:

The copper foil was laminated (bonded) to a prepreg (composite material of glass fiber fabric and epoxy resin) designated FR4 by the National Electrical Manufacturer's Association (NEMA) in two variants:
1. treated-side-down,
2. matte-side-down.

The peel strength of each of the treated sides and the matte side of the prepreg was then measured. The peel strength of the shiny side of the foil with the bonding treatment was found to be 1.7 N/mm (9.8 lbs/inch) of width of laminate, while the peel strength of the matte side of the foil was found to be 0.74 N/mm (4.2 lbs/inch).

Another matte-side-up laminate was prepared as described above and the "cleanability" of the matte surface was examined. The laminate was first immersed for 30 seconds in 5% solution of sodium hydroxide, at room temperature and then thoroughly rinsed. The laminate was then immersed in a commercial brown oxide a solution, a solution manufactured by Mac Dermid Compagny, 9804/9805 bronze oxide. The pink colored matte side of the copper immediately acquired a deep brown color, due to the reaction of copper with sodium chlorite which is the main constituent of the brown oxide solution. This indicates that this stainproofing film was completely removed by immersion in the solution of sodium hydroxide and that the stainproofing layer was easily removable. If the stainproofing layer had not been removed, the pink colored matte side would not have reacted with the brown oxide solution, and the deep brown color of cupric oxide would not have appeared on the copper surface.

## Claims

1. Method for protecting an electrodeposited copper foil having a matte surface (24) and an opposing shiny surface (22) against tarnishing and oxidation comprising the steps of
a) forming an electrolyte comprising an acueous solution containing hexavalent chromium ion-containing anions and zinc cations and having a pH from 3 to 4.5,
b) immersing said copper foil in said electrolyte, and
c) applying an oxidation-and-tarnish-resistant protective layer on the matte side of said copper foil by rendering said copper foil cathodic while immersed in said electrolyte thereby forming thereon said oxidation-and-tarnish-resistant protective layer consisting of zinc and one or more compounds of trivalent chromium having a thickness of less than 10 nm (100 Å) and having a zinc to chromium ratio of at least 1.1 by weight.

2. Method recording to claim 1, characterized in that said electrolyte has a pH of from 3,5 to 4.

3. Method according to claim 1 or 2, characterized in that said electrolyte contains mineral acid.

4. Method according to claim 3, wherein said mineral acid is phosphoric acid.

5. Method according to claim 1, characterized in than said zinc is contained in an acid electrolyte in the form of zinc sulfate and said aqueous solution contains a mineral acid to dissolve said zinc sulfate.

6. Method according to any of the preceding claims characterized by the additional step of applying an intermediate layer of zinc to the base foil prior to applying the protective layer.

7. Method according to any of the preceding claims characterized by the additional step of applying to said shiny side (22) a bonding treatment comprising an electrodeposited dendritic copper layer and an electrodeposited gilding copper layer on said dendritic copper layer.

## Patentansprüche

1. Verfahren zum Schützen einer durch galvanische Metallabscheidung hergestellten Kupferfolie, die eine matte Oberfläche (24) und eine gegenüberliegende glänzende Oberfläche (22) besitzt, gegen Anlaufen und Oxidation, wobei das Verfahren folgende Schritte enthält:
a) Bilden eines eine wäßrige Lösung umfassenden Elektrolyten, der Anionen mit sechswertigen Chromionen und Zinkkationen enthält und der einen pH zwischen 3 und 4,5 besitzt, und
b) Eintauchen der Kupferfolie in diesen Elektrolyten, und
c) Auftragen einer gegen Oxidation und Anlaufen widerstandsfähigen Schutzschicht auf die matte Seite der Kupferfolie, indem man die Kupferfolie kathodisch macht, während sie in den Elektrolyten eingetaucht wird, wodurch auf derselben die gegen Oxidation und Anlaufen widerstandsfähige Schutzschicht gebildet wird, die aus Zink und einer oder mehreren Verbindungen aus dreiwertigem Chrom besteht und eine Dicke von weniger als 10 nm (100 Å) aufweist sowie ein Verhältnis Zink/Chrom von mindestens 1:1 bezogen auf das Gewicht besitzt.

2. Verfahren gemäß Anspruch 1, dadurch gekennzeichnet, daß der Elektrolyt einen pH von 3,5 bis 4 aufweist.

3. Verfahren gemäß den Ansprüchen 1 oder 2, dadurch gekennzeichnet, daß der Elektrolyt eine Mineralsäure enthält.

4. Verfahren gemäß Anspruch 3, bei dem die Mineralsäure Phosphorsäure ist.

5. Verfahren gemäß Anspruch 1, dadurch gekennzeichnet, daß das Zink in einem sauren Elektrolyten in der Form von Zinksulfat enthalten ist und daß die wäßrige Lösung eine Mineralsäure zum Auflösen dieses Zinksulfates enthält.

6. Verfahren gemäß irgendeinem der vorhergehenden Ansprüche, gekennzeichnet durch den zusätzlichen Schritt des Auftragens einer Zwischenschicht aus Zink auf die Grundfolie vor dem Auftragen der Schutzschicht.

7. Verfahren gemäß irgendeinem der vorhergehenden Ansprüche, gekennzeichnet durch den zusätzlichen Schritt des Anlegens einer haftvermittelnden Behandlung auf die glänzende Seite (22), welche eine galvanische Abscheidung einer dentritischen Kupferschicht und eine galvanische Abscheidung einer vergoldenden Kupferschicht auf dieser dentritischen Kupferschicht enthält.

## Revendications

1. Procédé de protection d'une feuille de cuivre déposée par électrolyse possédant une surface mate (24) et une surface opposée brillante (22) contre le ternissement et l'oxydation comprenant les étapes:
a) de formation d'un électrolyte comprenant une solution aqueuse contenant des anions avec un ion de chrome hexavalent et des cations de zinc et présentant un pH allant de 3 à 4,5,
b) d'immersion de ladite feuille de cuivre dans ledit électrolyte, et
c) d'application d'une couche protectrice résistant à l'oxydation et au ternissement sur le côté mat de ladite feuille de cuivre en rendant ladite feuille de cuivre cathodique tandis qu'elle est immergée dans ledit électrolyte, formant ainsi sur celle-ci ladite couche protectrice résistant à l'oxydation et au ternissement, constituée de zinc et d'un ou de plusieurs composés de chrome trivalent, possédant une épaisseur ne dépassant pas 10 nm (100 Å) et présentant un rapport de zinc vis-à-vis du chrome d'au moins 1:1 en poids.

2. Procédé suivant la revendication 1, caractérisé en ce que ledit électrolyte possède un pH allant de 3,5 à 4.

3. Procédé suivant la revendication 1 ou 2, caractérisé en ce que ledit électrolyte contient un acide minéral.

4. Procédé suivant la revendication 3, dans lequel ledit acide minéral est de l'acide phosphorique.

5. Procédé suivant la revendication 1, caractérisé en ce que ledit zinc est contenu dans un électrolyte acide sous la forme de sulfate de zinc et ladite solution aqueuse contient un acide minéral pour dissoudre ledit sulfate de zinc.

6. Procédé suivant l'une quelconque des revendications précédentes, caractérisé par l'étape supplémentaire d'application d'une couche intermédiaire de zinc à la feuille de base avant l'application de la couche protectrice.

7. Procédé suivant l'une quelconque des revendications précédentes, caractérisé par l'étape supplémentaire d'application sur ledit côté brillant (22) d'un traitement assurant l'adhésion comprenant une couche de cuivre dendritique déposée par électrolyse et une couche d'encapsulation de cuivre déposée par électrolyse sur ladite couche de cuivre dendritique.
